(19)

Europäisches
Patentamt
European
Patent Office
Office européen
des brevets

(11)     **EP 2 363 378 A1**

(12)     **EUROPEAN PATENT APPLICATION**

(43) Date of publication:
**07.09.2011 Bulletin 2011/36**

(51) Int Cl.:
*C01G 51/00* [(2006.01)]     *H01L 35/00* [(2006.01)]

(21) Application number: **10305175.1**

(22) Date of filing: **23.02.2010**

(84) Designated Contracting States:
**AT BE BG CH CY CZ DE DK EE ES FI FR GB GR
HR HU IE IS IT LI LT LU LV MC MK MT NL NO PL
PT RO SE SI SK SM TR**
Designated Extension States:
**AL BA RS**

(71) Applicant: **Corning Incorporated
Corning NY 14831 (US)**

(72) Inventor: **Delorme, Fabian
45000, Orléans (FR)**

(74) Representative: **Nevant, Marc et al
Cabinet Beau de Loménie
158, rue de l'Université
75340 Paris Cedex 07 (FR)**

(54)     **Process for synthesizing layered oxides**

(57)     The present invention relates to the use of Layered Double Hydroxides (LDH) for synthesizing cobaltites, in particular $Ca_3Co_4O_9$. The invention also relates to a thermoelectric material comprising $Ca_3Co_4O_9$ as obtained from a LDH precursor.

EP 2 363 378 A1

**Description**

**Technical field of the invention**

The present invention relates to a process for synthesizing layered oxides with $CdI_2$-type layers, and to the use of the resulting oxides as thermoelectric materials.

**Background of the invention**

The existence of a global warming has now been largely demonstrated. The anthropic origin of this global warming is also accepted and the effect of greenhouse gas has been pointed out. Among greenhouse gas, the effect of $CO_2$ is preponderant, not because of a high greenhouse effect potential, which is in fact moderate, but due to the high amounts of $CO_2$ produced by various human activities (energy production, transportation, concrete synthesis etc.). The limitation of $CO_2$ emissions in order to limit the global warming is definitively one of the main objectives of the XXI[st] century. For large fixed emitters such as power plants or factories, solutions such as capture and geological storage, can be considered as efficient. However these techniques cannot be considered for small mobile emitters such as vehicles. For these small emitters, it is necessary to reduce as low as possible the $CO_2$ emissions.

Different solutions to reduce fuel consumption and $CO_2$ emissions are developed by the automobile industry. One of the most interesting solutions for short term applications is to use a thermoelectric device to produce electricity from the engine waste heat. Indeed, vehicles require more and more electricity for different security and comfort devices, whereas more than 30 % of the energy produced from the fuel is lost as waste heat. Thus, the electricity required for the different applications of the vehicle would be produced from the thermoelectric device, leading to decreased fuel consumption and consequently to decreased $CO_2$ emissions.

Thermoelectric materials, discovered in 1821, are solids that produce an electric current when joined together and subjected to a temperature difference across the junction. Fundamentally, thermoelectricity is concerned with the so-called Seebeck and Peltier effects. The first of these arises because of the property of certain materials, which creates an electrical potential V (expressed in Volts) between the ends of a solid submitted to a thermal gradient $\Delta T$ (expressed in degrees Kelvin). The Seebeck coefficient (S) is a measure of this induced electrical potential per the equation:

$$S = V/\Delta T$$

and is usually expressed in $\mu V/K$.

The Seebeck coefficient may be positive (p material) or negative (n material) depending on the nature and mobility of the charge carriers in the solid. This property is generally used to collect electrical energy from sources of heat. The Peltier effect is the opposite phenomenon, namely the creation of a temperature gradient in a material submitted to an electrical potential. It is generally exploited in cooling devices. For energy production, several pairs of n and p materials must usually be assembled in series in order to produce enough voltage for the required application.

From the material point of view, the properties required to allow making an efficient thermoelectric generator are:

- a high Seebeck S absolute value either for p (+) or n (-) material for a significant voltage;
- a high electrical conductivity $\sigma$, in order to deliver enough intensity;
- a low thermal conductivity $\kappa$, in order to maintain the thermal gradient at the origin of the voltage obtained.

To express the combination of the requirements on the three previously defined parameters, a figure of merit (ZT) of a material can be expressed in the form of:

$$ZT = \frac{S^2 \sigma}{\kappa},$$

where S is the Seebeck coefficient of the material (V/K), $\sigma$ is the electrical conductivity of the material (A/V.m) and $\kappa$ is the thermal conductivity of the material (W/m.K).

Materials presenting a ZT > 1, such as BiTe, PbTe, Skutterudites ($CoSb_3$) or $Mg_2Si$, are considered for applications in motor vehicles.

However, using thermoelectric materials within a vehicle engine requires resistance at high temperature (700-800°C) under oxidizing conditions (air atmosphere). Most of the materials presenting high ZT values are not stable in these conditions. Oxides appear as promising candidates as most of them are stable in these conditions. Moreover, the discovery of a large thermopower in the metallic oxide $Na_xCoO_2$ (Terasaki et al. 1997) has started an intense international research activity in the field of thermoelectric oxides.

Among all the oxides studied, layered oxides have shown high thermoelectric properties. Indeed ZT values close to 1 for single crystals have been reported for $Na_xCoO_2$ (Terasaki et al. 1997), $Ca_3CO_4O_9$ (Shikano et al. 2003) or $Bi_2Sr_2Co_2O_y$ (Funahashi et al. 2002). All these layered oxides present $CdI_2$-type layers (these layers refer to a crystallographic type of 2D planes composed by edge sharing octahedra). These layers can be separated by cations as in $Na_xCoO_2$ (Terasaki et al. 1997, op. cit.) or delafossites (Koumoto et al. 2001; Guilmeau et al. 2009), or by a various number of rocksalt layers such as in $Ca_3Co_4O_9$ (Shikano et al. 2003, op. cit.) or $BbSr_2Co_2O_y$ (Funahashi et al. 2002, op. cit.).

Different techniques have been proposed to synthesise these layered oxides with $CdI_2$-type layers. The most classical synthesis route is the standard solid state reaction of a mix of oxides and/or salts of each of the different constituting cations. For example, $Ca_3Co_4O_9$ is usually prepared from $CaCO_3$ and $Co_3O_4$ (Miyazaki et al. 2000), and less frequently from $CaCO_3$ and $Co_2O_3$ (Li et al. 1999), CaO and $Co_3O_4$ (Masset et al. 2000), or $CaCO_3$ and CoO (Liu et al. 2006). It has recently been proposed to synthesise layered oxides by the sol-gel method (Li et al. 2005) or by coprecipitation of oxalates (Zhang et al. 2008). The synthesis of the $Ca_3Co_4O_9$ phase using an in situ topotactic conversion of aligned platelet particles of $Co(OH)_2$ has been recently reported (Tani et al. 2003; US6,806,218).

## Summary of the invention

Conventional processes for preparing oxides with $CdI_2$-type layers appear to be limited in the choice of the metal precursors that can be used. The present invention is based on the discovery that Layered Double Hydroxides (LDH) can be used as precursors of layered cobaltites without impacting, and even improving, the thermoelectric properties thereof.

A first aspect of the invention therefore relates to the use of a Layered Double Hydroxide (LDH) for synthesizing layered cobaltites.

Another aspect of the invention relates to a thermoelectric material comprising a layered cobaltite obtained from a LDH.

A further aspect of the invention relates to a thermoelectric device comprising the aforementioned thermoelectric material.

## Brief description of the drawings

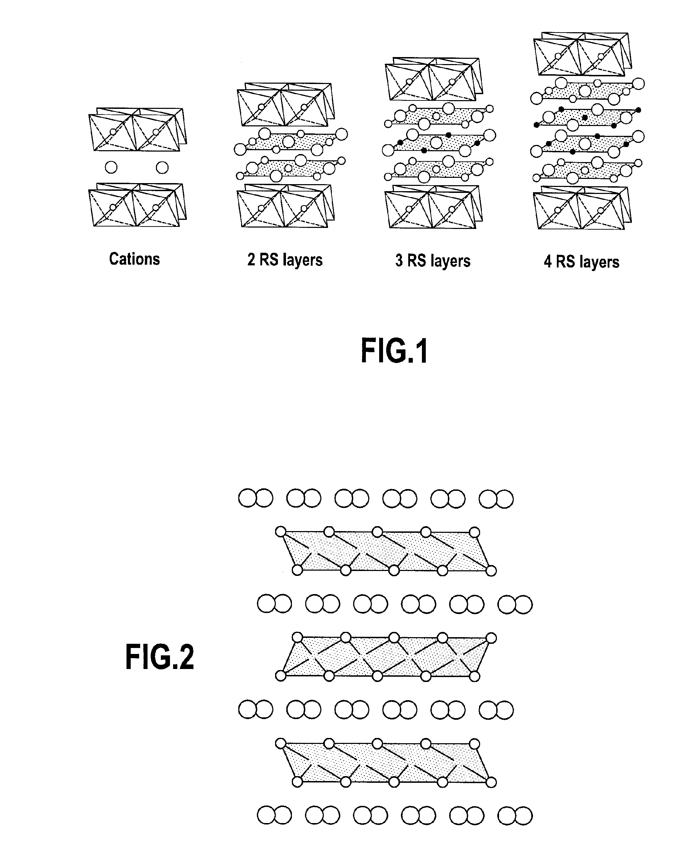

Figure 1 shows the structure of different layered oxides, from left to right: $CdI_2$-type layers separated by cations, by 2 rocksalt layers, by 3 rocksalt layers or by 4 rocksalt layers.
Figure 2 shows the structure of Layered Double Hydroxides.
Figure 3 shows X-ray diffraction patterns of two $Co^{II}Co^{III}$-LDH precursors of the invention, and of $\beta$-Co(OH)2.
Figure 4 shows X-ray diffraction patterns of a layered cobaltite, $Ca_3Co_4O_9$, synthesized from a LDH precursor and from a conventional mix of oxides and carbonates.

## Detailed description of the invention

The present invention provides a new route for the synthesis of layered cobaltites with $CdI_2$-type layers, wherein a Layered Double Hydroxide is used as a precursor of the cobaltites.

Layered Double Hydroxides (LDHs) are a wide family of compounds, also known as anionic clays or hydrotalcite-like compounds. A review of LDHs has been published by Cavani et al. in 1991.

Within the context of the present invention, the terms 'cobaltite' or 'layered cobaltite', are intended to mean oxides of cobalt and at least another metal element, said oxides having a $CdI_2$-type layered structure. Typical examples of cobaltites include, but are not limited to, $M_aCoO_2$ where M is an alkaline metal, $Ca_3Co_4O_9$ and $Bi_2Sr_2Co_2O_b$.

In one aspect, the invention therefore relates to the use of a Layered Double Hydroxide for synthesizing a layered cobaltite.

The Layered Double Hydroxide (LDH) can be represented by the following formula (I) or (II):

$$[M1_{1-x}Co_x(OH)_2]^{(2x-1)+}\ [A^{n-}]_{(2x-1)/n} \bullet m\ H_2O \qquad (I)$$

$$[M2_{1-x}M3_x(OH)_2]^{x+}\ [A^{n-}]_{x/n} \bullet m\ H_2O \qquad (II)$$

in which:

M1 is a monovalent metal, M2 is a divalent metal, M3 is a trivalent metal, A is an anion,
x is such that $0.1 \leq x \leq 0.5$, and

at least one of M2 and M3 is cobalt.

In the above formulae (I) and (II), m represents the number of water molecules which result from the synthesis of the LDH. This number can vary depending on the technique and operating conditions used.

Suitable monovalent metals which can used as metal M1 include Na, Li, K. M1 is preferably Na or Li, more preferably Na.

Suitable divalent metals which can used as metal M2 include Mg, Ca, Mn, Zn, Co, Cd, Cu and Ni. M2 is preferably Co or Ca.

Suitable trivalent metals which can be used as metal M3 include Co, Al, Fe, Cr and Ga. M3 is preferably Co.

Representative examples of LDHs which can be used in the present invention thus include those of formula (II) where M2 is $Co^{II}$ and M3 is $Co^{III}$ and those where M2 is Ca and M3 is $Co^{III}$.

The anion can be an inorganic anion such as chloride, fluoride, bromide, nitrate, sulfonate, carbonate or hydroxide (see e.g. Miyata 1983) or can be as complex as DNA (see e.g. Choy 2004). The anion is preferably an inorganic anion such as nitrate, hydroxide or carbonate.

In one embodiment, the precursor of the cobaltite comprises a mixture of a LDH of formula (I) as defined above and a source of metal M1 wherein M1 is as defined above.

In another embodiment, the precursor of the cobaltite comprises a mixture of a LDH of formula (II) as defined above and a source of metal M2 or M3 wherein M2 and M3 are as defined above.

Suitable sources of metals M1, M2 and M3 include carbonates, salts or hydroxides of said metals.

In yet another embodiment, the precursor of the cobaltite comprises a mixture of a LDH of formula (II) as defined above and another LDH of formula (III):

$$[M2_{1-x}M3_x(OH)_2]^{x+}\ [A^{n-}]_{x/n} \bullet m\ H_2O \qquad (III)$$

in which M2, A and x are as defined above for formula (I) and M3 is cobalt.

LDHs can be prepared by methods known in the art, for example following the procedure described by Cavani et al. (op. cit.) or Hu et al. (2009).

As explained above, cobaltites have a $CdI_2$-type layered structure. LDHs are presenting a similar structure that can be used as a template of the layered oxide structure.

In addition, LDHs are usually coprecipitated as nanoparticles, i.e. nano-sub-hexagonal-plate-like particles with a particle size close to 50 nm in the (a,b) planes and a few tenth or hundred of Å along the c-axis. Layered oxides obtained from traditional synthesis routes present a similar plate-like morphology but with higher dimensions

(usually a few microns in the (a,b) planes and hundred of nm along the c-axis). The use of LDHs as precursors allows smaller layered oxide particles to be obtained which in turn will lead to a decrease in thermal conductivity and thus to an increase in ZT. This proves to be of interest in the synthesis of thermoelectric materials, in particular $Ca_3Co_4O_9$.

Thus, according to another aspect, the present invention relates to a process for synthesizing a cobaltite of formula $Ca_3Co_4O_9$, which comprises the step of heat treating a mixture of:

(i) a LDH of formula (IIIa):

$$[M2_{1-x}M3_x(OH)_2]^{x+} [A^{n-}]_{x/n} \bullet m\ H_2O \quad (IIIa)$$

in which:

M2 and M3 each are Co, A is an anion, and
x is such that $0.1 \leq x \leq 0.5$,

and
(ii) either a source of calcium or a LDH of formula (IIIb)

$$[M2_{1-x}M3_x(OH)_2]^{x+} [A^{n-}]_{x/n} \bullet m\ H_2O \quad (IIIb)$$

in which:

M2 is Ca, M3 is Co, A is an anion, and
x is such that $0.1 \leq x \leq 0.5$.

The LDH of formula (IIIa) and either the source of calcium or the LDH of formula (IIIb) are preferably used in stoichiometric amounts. These materials are mixed before the heat treatment takes place. Mixing can be carried out e.g. in a tumble or by attrition according to methods well known to the skilled person. A preferred source of calcium is $CaCO_3$.

In one embodiment, the heat treatment can be carried out in two steps: the mixed precursors are first heated at a temperature of between about 700°C and about 950°C, and then sintered at a temperature of between about 700°C and about 1100°C, preferably at a temperature of between about 800°C and about 1050°C. Various sintering techniques can be used such as conventional sintering, hot pressing or spark plasma sintering.

In another embodiment, the heat treatment can be carried out by means of reactive sintering such as, for example, spark plasma sintering.

The resulting $Ca_3Co_4O_9$ has a positive Seebeck coefficient and can be used as a thermoelectric material.

Thermoelectric devices comprise a thermoelectric material of the n-type (having a negative Seebeck coefficient) and a thermoelectric material of the p-type (having a positive Seebeck coefficient). The p-type thermoelectric material of the present invention can be used as a part of a thermoelectric device.

In another aspect, the present invention therefore relates to a thermoelectric device comprising a thermoelectric material as defined above. One of the most interesting short term applications of thermoelectric devices is waste heat recovery, in particular waste heat recovery of automobile engines. Indeed, vehicles require more and more electricity for different security and comfort devices, whereas more than 30 % of the energy produced from the fuel is lost as waste heat. Waste heat recovery can be used to produce electricity using a thermoelectric device, leading to decreased fuel consumption and consequently to decreased $CO_2$ emissions.

The invention is illustrated by the examples below. In these examples, the following techniques were used to characterize the LDH and layered cobaltites of the invention.

Sintering was performed by Spark Plasma Sintering (SPS, FCT Systeme GmbH HP D 25). The synthesised powders were placed in a 20 mm diameter graphite die. A pressure of 70 MPa was applied whereas the temperature was raised at 100°C/min up to 850°C for 5 minutes. Then the sample was cooled at 100°C/min to room temperature. The obtained pellets were then polished to remove the graphite foils used during the SPS process and cut as bars for thermoelectric properties measurements or core drilled (12.7 mm diameter, 2 mm in thickness) for thermal conductivity measurements.

Thermoelectric properties of the sintered samples were determined from simultaneous measurement of resistivity and Seebeck coefficient in a ZEM III equipment (ULVAC Technologies) and of thermal conductivity. The thermal conductivity, k, was determined from thermal diffusivity, a, heat capacity, $C_p$, and density p, using the following equation : $\kappa = \rho\ a\ C_p$. The thermal diffusivity was measured using the laser flash diffusivity technique (Netzsch LFA 427) from room temperature to 800°C in air atmosphere. The thermal diffusivity measurement of all specimens was carried out three times at each temperature. The heat capacity of the materials was measured from room temperature to 800°C, with a heating rate of $10°C.min^{-1}$ in platinum crucibles and in air atmosphere, using differential scanning calorimetry (Netzsch DSC 404 C pegasus).

Powder X-ray diffraction (XRD) patterns have been performed on a Philips X'PERT Pro θ/2θ diffractometer equipped with an X'CELERATOR real time multiple strip detector, using Cu-K$_\alpha$ radiation and operating at 45 kV and 40 mA at room temperature. The scans have been recorded from 5 to 140° (2θ) with a step of 0.00167° and a counting time of 40s per step.

Example 1: Synthesis of a Co$^{II}$Co$^{III}$ LDH

An aqueous solution was prepared, containing 0.01 mole of cobalt nitrate (Co(NO$_3$)$_2$.6H$_2$O, VWR, 99.7 % purity) and 10 g of PEG (Aldrich) in 50 ml of water. A 20% NH$_3$ solution (Fischer) was added dropwise to the above-mentioned aqueous solution at a constant rate through a peristaltic pump, according to the varying pH method (as described in Journal of Physics and Chemistry of Solids 2008, 69(5-6), 1088-1090). The pH was monitored by a pH-meter (Mettler DL67 Titrator) and the experiment was stopped when the pH reached a value of 9.

The resulting slurry was aged under vigorous stirring during 24 h at room temperature, and then centrifuged at 4000 rpm during 5 min (Eppendorf Centrifuge 5403). The supernatant was removed and the residue was washed three times with deionized water at room temperature, then dried overnight in a furnace at 60°C (Binder).

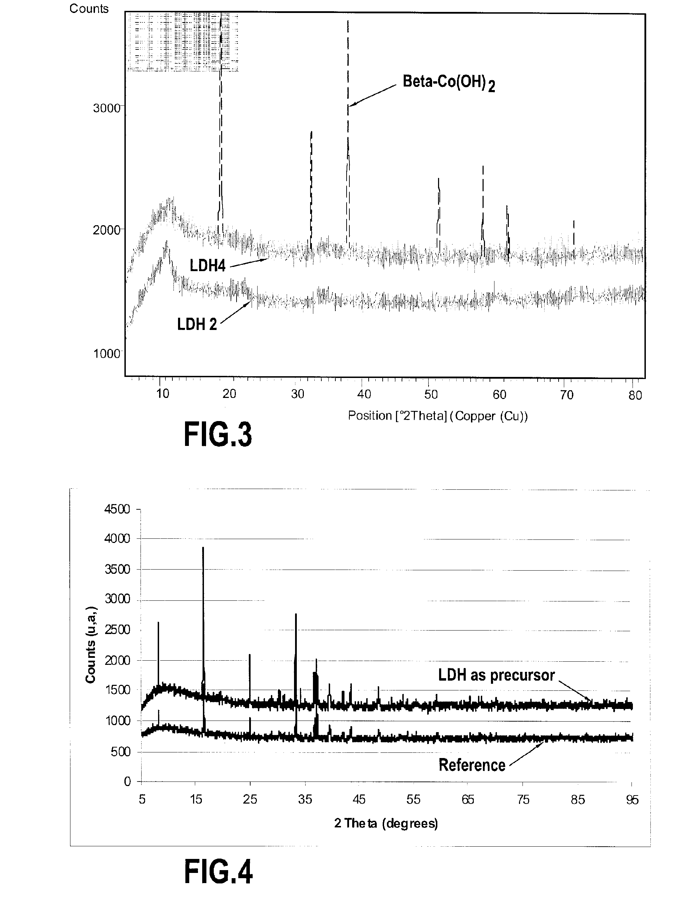

Figure 3 shows the X-ray diffraction pattern of the resulting powder (LDH2), compared to that of β-Co(OH)2 used as a reference. The powder has a pattern which does not have the structure of β-Co(OH)$_2$ but rather has the layered structure of a layered double hydroxide (as recently evidenced by Hu et al. 2009, op. cit.).

Example 2: Synthesis of a Co$^{II}$Co$^{III}$ LDH

A first aqueous solution was prepared, containing 0.01 mole of cobalt nitrate (Co(NO$_3$)$_2$.6H$_2$O, VWR, 99.7 % purity) in 50 ml of water. A second solution was prepared by introducing 280 ml of a 3.5 M NaOH solution (solid NaOH from Fischer (98%)) in 1000 ml of a 1M Na$_2$CO$_3$ solution (Merck, 99.5 %). The second solution was added dropwise to the first solution at a constant rate through a peristaltic pump, according to the varying pH method (as described in Journal of Physics and Chemistry of Solids 2008, 69(5-6), 1088-1090). The pH was monitored by a pH-meter (Mettler DL67 Titrator) and the experiment was stopped when the pH reached a value of 9.

The resulting slurry was aged under vigorous stirring during 24 h at room temperature, and then centrifuged at 4000 rpm during 5 min (Eppendorf Centrifuge 5403). The supernatant was removed and the residue was washed three times with deionized water at room temperature, then dried overnight in a furnace at 60°C (Binder).

Figure 3 shows the X-ray diffraction pattern of the resulting powder (LDH4), compared to that of β-Co(OH)$_2$ used as a reference. The powder has a pattern which does not have the structure of β-Co(OH)$_2$ but rather has the layered structure of a layered double hydroxide (as recently evidenced by Hu et al. 2009, op. cit.).

Example 3: Synthesis of Ca$_3$Co$_4$O$_9$

Stoichiometric amounts of the Co$^{II}$Co$^{III}$ LDH_of example 2 and of CaCO$_3$ (Sigma Aldrich, > 99 % purity) were thoroughly mixed for 5 min at 400 rpm in an agate ball mill (Retsch PM 100). The resulting powder was heated at 850°C for 8 h in an alumina crucible at a rate of 5°C/min and then slowly cooled down, whereby a powdered oxide was obtained. Sintering was then performed by Spark Plasma Sintering (SPS, FCT Systeme GmbH HP D 25) as follows. The powdered oxide was placed in a 20 mm diameter graphite die. A pressure of 70 MPa was applied whereas the temperature was raised at 100°C/min up to 850°C for 5 minutes. Then the sample was cooled at 100°C/min to room temperature. The obtained pellets were then polished to remove the graphite foils used during the SPS process and cut as bars for thermoelectric properties measurements or core drilled (12.7 mm diameter, 2 mm in thickness) for thermal conductivity measurements.

Figure 4 shows that this oxide exhibits a Ca$_3$Co$_4$O$_9$ phase, demonstrating that the Co$^{II}$Co$^{III}$ LDH is a suitable precursor for the synthesis of the layered oxide Ca$_3$Co$_4$O$_9$.

Example 4: Thermoelectric properties of Ca$_3$Co$_4$O$_9$

The thermoelectric properties of the oxide of example 3 were compared to those of Ca$_3$Co$_4$O$_9$ obtained by conventional mixing of CaCO$_3$ (Sigma Aldrich, > 99 % purity) with either Co$_3$O$_4$ having an average particle size of the order of a few micrometers (Sigma Aldrich; reference example 1) or Co$_3$O$_4$ having an average particle size of a few nanometers (Sigma Aldrich, 99.8% purity; reference example 2), and subsequent heating of the resulting mixture. Samples were sintered under the conditions described in example 3. The results are presented in the table below.

|  | Power Factor | Kappa | ZT |
|---|---|---|---|
| Example 2 | 3.07 10$^{-4}$ | 1.67 | 1.83 10$^{-1}$ |

**EP 2 363 378 A1**

(continued)

|  | Power Factor | Kappa | ZT |
|---|---|---|---|
| Ref. Example 1 | $3.14 \times 10^{-4}$ | 2.10 | $1.50 \times 10^{-1}$ |
| Ref. Example 2 | $3.20 \times 10^{-4}$ | 1.70 | $1.90 \times 10^{-1}$ |

<u>LIST OF REFERENCES</u>

1. Terasaki I., Sasago Y., Uchinokura K. (1997) Large thermoelectric power in NaCo2O4 single crystals. Physical Review B 56, R12685-R12687.

2. Shikano M. & Funahashi R. (2003) Electrical and thermal properties of single-crystalline (Ca2CoO3)0.7CoO2 with a Ca3Co409 structure. Applied Physics Letters 82, 1851-1853.

3. Funahashi R. & Shikano M. (2002) Bi2Sr2Co2Oy whiskers with high thermoelectric figure of merit. Applied Physics Letters 81, 1459-1461.

4. Koumoto K., Koduka H., Seo W-S. (2001) Thermoelectric properties of single crystal CuAlO2 with a layered structure. Journal of Materials Chemistry 11, 251-252.

5. Guilmeau E., Maignan A., Martin C. (2009) Thermoelectric oxides : effect of doping in delafossites and zinc oxide. Journal of electronic Materials 38, 1104-1108.

6. Miyazaki Y., Kudo K., Akoshima M., Ono Y., Koike Y., Kajitani T. (2000) Low-temperature thermoelectric properties of the composite crystal [Ca2CoO3.34]0.614(CoO2). Jpn. J. Appl. Phys. 39, L531-L533.

7. Li S., Funahashi R., Matsubara I., Ueno K., Yamada H. (1999) High temperature thermoelectric properties of oxide Ca9Co12O28. Journal of Materials Chemistry 9, 1659-1660.

8. Masset A.C., Michel C., Maignan A., Hervieu M., Toulemonde O., Studer F., Raveau B (2000) Misfit-layered cobaltite with an anisotropic giant magnetoresistance : Ca3Co4O9. Physical Review B 62, 166-175.

9. Liu C-J., Huang L-C, Wang J-S. (2006) Improvement of the thermoelectric characteristics of Fe-doped misfit-layered Ca3Co4-xFexO9+δ (x = 0, 0.05, 0.1, and 0.2). Applied Physics Letters 89, 204102-1-204102-3.

10. Li D., Qin X.Y., Gu Y.J., Zhang J. (2005) The effect of Mn substitution on thermoelectric properties of Ca3MnxCo4-xO9 at low temperatures. Solid State Communications 134, 235-238.

11. Zhang Y. & Zhang J. (2008) Rapid reactive synthesis and sintering of textured Ca3Co4O9 ceramics by spark plasma sintering. Journal of Materials Processing Technology 208, 70-74.

12. Tani T., Itahara H., Xia C., Sugiyama J. (2003) Topotactic synthesis of highly-textured thermoelectric cobaltites. Journal of Materials Chemistry 13, 1865-1867.

13. Cavani F., Trifiro F., Vaccari A. (1991) Hydrotalcite-type anionic clays:

preparation, properties and applications. Catalysis Today 11, 173-301.

14. Miyata S. (1983) Anion-exchange properties of hydrotalcite-like compounds. Clays and Clay Minerals 31, 305-311.

15. Choy J-H. (2004) Intercalative route to heterostructured nanohybrid. Journal of Physics and Chemistry of Solids 65, 373-383.

16. Hu Z-A., Xie Y-L., Wang Y.X., Xie L.J., Fu G-R., Jin X-Q., Zhang Z-Y., Yang Y-Y., Wu H-Y. (2009) Synthesis of α-cobalt hydroxides with different intercalated anions and effects of intercalated anions on their morphology, basal plane spacing, and capacitive property. J. Phys. Chem. C 113, 12502-12508.

**Claims**

1. Use of a Layered Double Hydroxide (LDH) for synthesizing a cobaltite, wherein the LDH has the following formula (I) or (II):

$$[M1_{1-x}Co_x(OH)_2]^{(2x-1)+} [A^{n-}]_{(2x-1)/n} \cdot m\, H_2O \qquad (I)$$

$$[M2_{1-x}M3_x(OH)_2]^{x+} [A^{n-}]_{x/n} \bullet m \ H_2O \quad (II)$$

in which:

M1 is a monovalent metal, M2 is a divalent metal, M3 is a trivalent metal, A is an anion,
x is such that $0.1 \leq x \leq 0.5$, and
at least one of M2 and M3 is cobalt.

2. Use according to claim 1, wherein M1 is selected from Na, Li and K; M2 is selected from Mg, Ca, Mn, Zn, Co, Cd, Cu and Ni; and M3 is selected from Co, Al, Fe, Cr and Ga.

3. Use according to claim 1 or 2 of a LDH of formula (I) wherein M1 is Na.

4. Use according to claim 1 or 2 of a LDH of formula (II) wherein M2 is selected from Co and Ca and M3 is Co.

5. A process for synthesizing a cobaltite of formula $Ca_3Co_4O_9$, which comprises the step of heat treating a mixture of:

(i) a LDH of formula (IIIa):

$$[M2_{1-x}M3_x(OH)_2]^{x+} [A^{n-}]_{x/n} \bullet m \ H_2O \quad (IIIa)$$

in which:

M2 and M3 each are Co, A is an anion, and
x is such that $0.1 \leq x \leq 0.5$,

and
(ii) either a source of calcium or a LDH of formula (IIIb)

$$[M2_{1-x}M3_x(OH)_2]^{x+} [A^{n-}]_{x/n} \bullet m \ H_2O \quad (IIIb)$$

in which:

M2 is Ca, M3 is Co, A is an anion, and
x is such that $0.1 \leq x \leq 0.5$.

6. The process according to claim 5, wherein the source of calcium is $CaCO_3$.

7. Use of a cobaltite of formula $Ca_3Co_4O_9$ obtained by the process of claim 5 or 6 as a thermoelectric material.

8. A thermoelectric device comprising a thermoelectric material as defined in claim 7.

9. Use of the thermoelectric device of claim 8 for the waste heat recovery of automobile engines

10. A method for recovering waste heat from automobile engines wherein a thermoelectric device as defined in claim 8 is used.

| Cations | 2 RS layers | 3 RS layers | 4 RS layers |

## FIG.1

## FIG.2

**FIG.3**

**FIG.4**

Europäisches
Patentamt

European
Patent Office

Office européen
des brevets

## PARTIAL EUROPEAN SEARCH REPORT

under Rule 62a and/or 63 of the European Patent Convention.
This report shall be considered, for the purposes of
subsequent proceedings, as the European search report

Application Number

EP 10 30 5175

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | BRITTO S ET AL: "Solution decomposition of the layered double hydroxide of Co with Fe: Phase segregation of normal and inverse spinels" JOURNAL OF COLLOID AND INTERFACE SCIENCE, ACADEMIC PRESS, NEW YORK, NY, US LNKD-DOI:10.1016/J.JCIS.2008.05.041, vol. 325, no. 2, 15 September 2008 (2008-09-15), pages 419-424, XP023785441 ISSN: 0021-9797 [retrieved on 2008-05-28] * the whole document * ----- | 1,2 | INV. C01G51/00 H01L35/00 |
| X | ELLY L. UZUNOVA, IVAN G. MITOV, AND DIMITAR G. KLISSURSKI: "Synthesis of Nano-Dimensional Iron-Cobalt Spinel Mixed Oxides from Layered-Type Carbonate Hydroxide Precursors" BULL. CHEM. SOC. JPN., vol. 70, no. 8, August 1997 (1997-08), pages 1985-1993, XP002587558 * the whole document * ----- -/-- | 1,2 | |

TECHNICAL FIELDS
SEARCHED    (IPC)

C01G
H01L

### INCOMPLETE SEARCH

The Search Division considers that the present application, or one or more of its claims, does/do
not comply with the EPC so that only a partial search (R.62a, 63) has been carried out.

Claims searched completely :

Claims searched incompletely :

Claims not searched :

Reason for the limitation of the search:

see sheet C

| Place of search | Date of completion of the search | Examiner |
|---|---|---|
| Munich | 18 June 2010 | King, Ruth |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04E07)

Europäisches
Patentamt

European
Patent Office

Office européen
des brevets

**PARTIAL EUROPEAN SEARCH REPORT**

Application Number

EP 10 30 5175

## DOCUMENTS CONSIDERED TO BE RELEVANT

| Category | Citation of document with indication, where appropriate, of relevant passages | Relevant to claim |
|---|---|---|
| X | MARGARITA DEL ARCO, RAQUEL TRUJILLANO AND VICENTE RIVES: "Cobalt-iron hydroxycarbonate and their evolution to mixed oxides with spinel structure" J. MATER. CHEM., vol. 8, no. 3, 1998, pages 761-767, XP002587559 * the whole document * ----- | 1,2 |
| X | LU ET AL: "Synthesis of layered cathode material Li[CoxMn1-x]O2 from layered double hydroxides precursors" JOURNAL OF SOLID STATE CHEMISTRY, ORLANDO, FL, US LNKD-DOI:10.1016/J.JSSC.2007.04.001, vol. 180, no. 5, 1 May 2007 (2007-05-01), pages 1775-1782, XP022083623 ISSN: 0022-4596 * the whole document * ----- | 1 |
| X | US 2003/013596 A1 (ITAHARA HIROSHI [JP] ET AL) 16 January 2003 (2003-01-16) | 7-10 |
| Y | * paragraphs [0001], [0022], [0050], [0081], [0082], [0089], [0097], [0099], [0101]; example 2 * ----- | 5,6 |
| X | US 2007/039641 A1 (HU YUFENG [US] ET AL) 22 February 2007 (2007-02-22) * paragraphs [0095], [0122], [0130] * ----- | 7-10 |

-/--

CLASSIFICATION OF THE APPLICATION (IPC)

TECHNICAL FIELDS SEARCHED (IPC)

EPO FORM 1503 03.82 (P04C10)

**PARTIAL EUROPEAN SEARCH REPORT**

Application Number

EP 10 30 5175

| | DOCUMENTS CONSIDERED TO BE RELEVANT | | CLASSIFICATION OF THE APPLICATION (IPC) |
|---|---|---|---|
| Category | Citation of document with indication, where appropriate, of relevant passages | Relevant to claim | |
| Y,D | ZHONG-AI HU, YU-LONG XIE, YAO-XIAN WANG, LI-JING XIE, GUO-RUI FU, XIAO-QING JIN, ZI-YU ZHANG, YU-YING YANG AND HONG-YING WU: "Synthesis of alpha-Cobalt Hydroxides with Different INtercalated Anions and Effects of INtercalated Anions on Their Morphology, Basal Plane Spacing, and Capacitive Property" J. PHYS. CHEM. C, vol. 113, 16 July 2009 (2009-07-16), pages 12502-12508, XP002587560 * the whole document * ----- | 5,6 | |
| A,D | CAVANI F ET AL: "Hydrotalcite-type anionic clays: preparation, properties and applications" CATALYSIS TODAY, ELSEVIER, NL LNKD-DOI:10.1016/0920-5861(91)80068-K, vol. 11, 1 January 1991 (1991-01-01), pages 173-301, XP002497610 ISSN: 0920-5861 * the whole document * ----- | 1-10 | TECHNICAL FIELDS SEARCHED (IPC) |

EPO FORM 1503 03.82 (P04C10)

Europäisches Patentamt

European Patent Office

Office européen des brevets

**INCOMPLETE SEARCH**

**SHEET C**

Claim(s) completely searchable:
    6-10

Claim(s) searched incompletely:
    1-5

Reason for the limitation of the search:

Claims 1-5 are not supported by the description as required by Article 84 EPC, as their scope is broader than justified by the description and drawings. Furthermore said claims do not meet the requirements of Article 83 EPC, since the application is sufficiently disclosed according to Article 83 only in respect to a part of the claimed subject-matter.
The reasons are the following:
Neither in the application nor in the cited documents there is no procedure provided for preparing compounds of the formula [M(I)1-xCox(OH)2](2x-1)+[An-](2x-1)/n * m H2O. In paragraph 3.4 on page 190 of the review article "Hydrotalcite-type anionic clays: preparation, properties and applications" (Catalysis Today 11 (1991), 173-301) compounds with the formula [M(I)1-xM(III)x(OH)2](2x-1)+[An-](2x-1)/n * m H2O are described. It is explicitly stated that the preparation of hydrotalcite-type compounds comprising a monovalent metal ion is limited to lithium compounds having an ionic radius comparable to that of the divalent ions forming hydrotalcites. Furthermore only a lithium aluminum layered double hydroxide (LDH) is described, and the applicant did no provide any evidence for the existence of alkali metal cobalt LDHs.
The same reasoning applies for claim 5, since a procedure for the preparation of a calcium cobalt LDH is not described and in the documents cited by the applicant no indication is given that and how such a Ca-Co LDH is obtainable.
It seems therefore to be impossible for the skilled person to carry out these parts of the present invention, since neither the common general knowledge nor the present application provides him with any information guiding him in preparing the starting products used in claim 1 and 5.
Hence claims 1-5 do not meet the meet the requirements of Article 83 EPC, since the application is sufficiently disclosed according to Article 83 only in respect to a part of the claimed subject-matter.
Thus, the search report has been drawn up on the basis of the subject-matter searched (Rule 63(2) EPC), which is what as far as can be understood, could reasonably be expected to be claimed later in the procedure, and the corresponding claims, namely claims 1, 2 and 5, all partially, and claims 6-10.

Europäisches
Patentamt

European
Patent Office

Office européen
des brevets

**Application Number**

EP 10 30 5175

---

**CLAIMS INCURRING FEES**

The present European patent application comprised at the time of filing claims for which payment was due.

☐ Only part of the claims have been paid within the prescribed time limit. The present European search report has been drawn up for those claims for which no payment was due and for those claims for which claims fees have been paid, namely claim(s):

☐ No claims fees have been paid within the prescribed time limit. The present European search report has been drawn up for those claims for which no payment was due.

---

**LACK OF UNITY OF INVENTION**

The Search Division considers that the present European patent application does not comply with the requirements of unity of invention and relates to several inventions or groups of inventions, namely:

see sheet B

☐ All further search fees have been paid within the fixed time limit. The present European search report has been drawn up for all claims.

☒ As all searchable claims could be searched without effort justifying an additional fee, the Search Division did not invite payment of any additional fee.

☐ Only part of the further search fees have been paid within the fixed time limit. The present European search report has been drawn up for those parts of the European patent application which relate to the inventions in respect of which search fees have been paid, namely claims:

☐ None of the further search fees have been paid within the fixed time limit. The present European search report has been drawn up for those parts of the European patent application which relate to the invention first mentioned in the claims, namely claims:

☐ The present supplementary European search report has been drawn up for those parts of the European patent application which relate to the invention first mentioned in the claims (Rule 164 (1) EPC).

Europäisches
Patentamt

European
Patent Office

Office européen
des brevets

**LACK OF UNITY OF INVENTION
SHEET B**

**Application Number**

EP 10 30 5175

The Search Division considers that the present European patent application does not comply with the requirements of unity of invention and relates to several inventions or groups of inventions, namely:

1. claims: 1-4

       Use of layered double hydroxides for synthesising a layered cobaltite.
                                  ---

2. claims: 5-10

       Process for synthesising Ca3Co4O9 and the use of said compound as a thermoelectric material
                                  ---

**ANNEX TO THE EUROPEAN SEARCH REPORT
ON EUROPEAN PATENT APPLICATION NO.**

EP 10 30 5175

This annex lists the patent family members relating to the patent documents cited in the above-mentioned European search report.
The members are as contained in the European Patent Office EDP file on
The European Patent Office is in no way liable for these particulars which are merely given for the purpose of information.

18-06-2010

| Patent document cited in search report | Publication date | Patent family member(s) | Publication date |
|---|---|---|---|
| US 2003013596 A1 | 16-01-2003 | NONE | |
| US 2007039641 A1 | 22-02-2007 | NONE | |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6806218 B, Tani

**Non-patent literature cited in the description**

- *Journal of Physics and Chemistry of Solids,* 2008, vol. 69 (5-6), 1088-1090
- **TERASAKI I. ; SASAGO Y. ; UCHINOKURA K.** Large thermoelectric power in NaCo2O4 single crystals. *Physical Review B,* 1997, vol. 56, R12685-R12687
- **SHIKANO M. ; FUNAHASHI R.** Electrical and thermal properties of single-crystalline (Ca2CoO3)0.7CoO2 with a Ca3Co4O9 structure. *Applied Physics Letters,* 2003, vol. 82, 1851-1853
- **FUNAHASHI R. ; SHIKANO M.** Bi2Sr2Co2Oy whiskers with high thermoelectric figure of merit. *Applied Physics Letters,* 2002, vol. 81, 1459-1461
- **KOUMOTO K. ; KODUKA H. ; SEO W-S.** Thermoelectric properties of single crystal CuAlO2 with a layered structure. *Journal of Materials Chemistry,* 2001, vol. 11, 251-252
- **GUILMEAU E. ; MAIGNAN A. ; MARTIN C.** Thermoelectric oxides : effect of doping in delafossites and zinc oxide. *Journal of electronic Materials,* 2009, vol. 38, 1104-1108
- **MIYAZAKI Y. ; KUDO K. ; AKOSHIMA M. ; ONO Y. ; KOIKE Y. ; KAJITANI T.** Low-temperature thermoelectric properties of the composite crystal [Ca2CoO3.34]0.614(CoO. *Jpn. J. Appl. Phys.,* 2000, vol. 39, L531-L533
- **LI S. ; FUNAHASHI R. ; MATSUBARA I. ; UENO K. ; YAMADA H.** High temperature thermoelectric properties of oxide Ca9Co12O. *Journal of Materials Chemistry,* 1999, vol. 9, 1659-1660
- **MASSET A.C. ; MICHEL C. ; MAIGNAN A. ; HERVIEU M. ; TOULEMONDE O. ; STUDER F. ; RAVEAU B.** Misfit-layered cobaltite with an anisotropic giant magnetoresistance : Ca3Co4O. *Physical Review B,* 2000, vol. 62, 166-175

- **LIU C-J. ; HUANG L-C ; WANG J-S.** Improvement of the thermoelectric characteristics of Fe-doped misfit-layered Ca3Co4-xFexO9+δ (x = 0, 0.05, 0.1, and 0.2. *Applied Physics Letters,* 2006, vol. 89, 204102-1204102-3
- **LI D. ; QIN X.Y. ; GU Y.J. ; ZHANG J.** The effect of Mn substitution on thermoelectric properties of Ca3MnxCo4-xO9 at low temperatures. *Solid State Communications,* 2005, vol. 134, 235-238
- **ZHANG Y ; ZHANG J.** Rapid reactive synthesis and sintering of textured Ca3Co4O9 ceramics by spark plasma sintering. *Journal of Materials Processing Technology,* 2008, vol. 208, 70-74
- **TANI T. ; ITAHARA H. ; XIA C. ; SUGIYAMA J.** Topotactic synthesis of highly-textured thermoelectric cobaltites. *Journal of Materials Chemistry,* 2003, vol. 13, 1865-1867
- **CAVANI F. ; TRIFIRO F. ; VACCARI A.** *Hydrotalcite-type anionic clays,* 1991
- **MIYATA S.** Anion-exchange properties of hydrotalcite-like compounds. *Clays and Clay Minerals,* 1983, vol. 31, 305-311
- **CHOY J-H.** Intercalative route to heterostructured nanohybrid. *Journal of Physics and Chemistry of Solids,* 2004, vol. 65, 373-383
- **HU Z-A. ; XIE Y-L. ; WANG Y.X. ; XIE L.J. ; FU G-R. ; JIN X-Q. ; ZHANG Z-Y. ; YANG Y-Y. ; WU H-Y.** Synthesis of α-cobalt hydroxides with different intercalated anions and effects of intercalated anions on their morphology, basal plane spacing, and capacitive property. *J. Phys. Chem. C,* 2009, vol. 113, 12502-12508